# EUROPÄISCHE PATENTSCHRIFT

(11) **EP 3 580 825 B1**
(45) Veröffentlichungstag und Bekanntmachung des Hinweises auf die Patenterteilung: **26.01.2022**
(21) Anmeldenummer: 17794704.1
(22) Anmeldetag: 26.10.2017
(51) Int. Cl.: H02J 1/02, H02M 1/15

(54) **AKTIVER FILTER FÜR BIPOLARE SPANNUNGSQUELLEN**
ACTIVE FILTER FOR BIPOLAR VOLTAGE SOURCES
FILTRE ACTIF POUR SOURCES DE TENSION BIPOLAIRES

(30) Priorität: 09.02.2017 DE 102017102608
(43) Veröffentlichungstag der Anmeldung: 18.12.2019
(73) Patentinhaber: AVL Software And Functions GmbH, 93059 Regensburg (DE)
(72) Erfinder: ARNDT, Bastian, 93053 Regensburg (DE); REINDL, Hartwig, 93055 Regensburg (DE); OLBRICH, Peter, 94553 Mariaposching (DE)
(74) Vertreter: Louis Pöhlau Lohrentz
(86) Internationale Anmeldenummer: PCT/EP2017/077518
(87) Internationale Veröffentlichungsnummer: WO 2018/145781

(56) Entgegenhaltungen:
- EP-A1- 1 686 678
- EP-A1- 2 571 095
- EP-A1- 3 255 770
- US-A- 4 594 648

## Beschreibung

Die Erfindung betrifft eine Vorrichtung zur Unterdrückung von Störsignalen für eine bipolare Spannungsquelle mit den Merkmalen des Oberbegriffs des Anspruchs 1.

Aus der Praxis sind Filteranordnungen zur Störsignalunterdrückung für Antriebsstränge für Fahrzeuge bekannt. Aufgrund der vorherrschenden hohen Spannungen werden hierfür fast ausschließlich passive Bauelemente eingesetzt, welche groß und teuer sind.

Ferner sind aktive Filterkonzepte bekannt, z.B. aus der WO 2003/005578 A1, welche aber hauptsächlich für Anwendungen in der Signalverarbeitung, oder für Anwendungen bei denen niedrigere Spannungen und/oder niedrigere Leistungen vorherrschen, verwendet werden.

Aus der EP 2 571 095 A1 ist ein System zum Schutz von Batterien bekannt, wobei das System Störsignale erzeugen oder unterdrücken kann. Der Abgriff und die Einspeisung bei der Unterdrückung des Störsignals erfolgt an getrennten Orten in der Leitung. Derartige aktive Filter mit getrennten Abgriffen und Einspeisungen sind bereits aus der US 4 594 648 A oder der EP 3 255 770 A1 bekannt. Allgemeine Anordnungen von aktiven Filtern ohne konkrete Schaltungsbeispiele sind aus der EP 1 686 678 A1 bekannt.

Aufgabe der Erfindung ist es eine verbesserte, kostengünstige und vorteilhafte Vorrichtung zum Unterdrücken von Störsignalen zur Verfügung zu stellen, die auch bei höheren Spannungen einen geringeren Platzbedarf und eine hohe Störsignalunterdrückung aufweist.

Diese Aufgabe wird mit dem Gegenstand des Anspruchs 1 und dem Verfahren des Anspruchs 14 erfindungsgemäß gelöst.

Bei der erfindungsgemäßen Lösung handelt es sich um eine Vorrichtung zur Unterdrückung von Störsignalen für bipolare Spannungsquellen, insbesondere für Hochvoltspannungsquellen in einem Antriebsstrang eines Elektrofahrzeugs. Diese Vorrichtung umfasst eine positive Versorgungsleitung und eine negative Versorgungsleitung einer Spannungsquelle und eine Verstärkerschaltung mit einer Vorstufe, deren Eingang mittels eines galvanisch getrennten Abgriffs symmetrisch mit der positiven Versorgungsleitung und der negativen Versorgungsleitung der bipolaren Spannungsquelle verbunden ist um ein Störsignal abzugreifen, und mit einer von der Vorstufe angesteuerten Endstufe, deren Ausgang über jeweils einen Ausgangskondensator mit der positiven Versorgungsleitung und der negativen Versorgungsleitung symmetrisch verbunden ist, um ein Korrektursignal einzuspeisen. Wesentlich dabei ist, dass die positive Versorgungsleitung und die negative Versorgungsleitung jeweils zwischen der Stelle des Abgriffs des Störsignals und der Spannungsquelle entweder eine Drossel aufweist, und/oder eine höhere Impedanz als zwischen der Stelle des Abgriffs des Störsignals und einer Störquelle aufweist, und wobei der Abgriff des Störsignals und die Einspeisung des Korrektursignals jeweils an derselben Stelle einer Versorgungsleitung erfolgt.

Die erfindungsgemäße Vorrichtung bewirkt, dass ein an einer Versorgungsleitung abgegriffenes Störsignal in der Verstärkerschaltung verstärkt und von der Endstufe mit entgegengesetzter Polarität als Korrektursignal wieder in die Versorgungsleitung eingespeist wird. Dadurch wird das Störsignal unterdrückt. Der Abgriff und die Einspeisung erfolgt galvanisch getrennt. Die galvanische Trennung zwischen dem Verstärker und der Versorgungsleitung im Abgriff des Störsignales sowie bei der Einkopplung des Korrektursignales ermöglicht, dass der Verstärker auf einem niedrigeren Spannungslevel betrieben wird als die zu filternde Versorgungsleitung. Dadurch ist die Verwendung der erfindungsgemäßen Vorrichtung auch bei hohen Spannungen möglich.

Die Drossel stellt eine erhöhte Induktivität dar und verhindert, dass das eingespeiste Korrektursignal von einer kleinen Impedanz der Stromquelle belastet wird. Über die Drossel wird somit eine erhöhte Störsignalunterdrückung erzielt. Durch den Abgriff und die Einspeisung an derselben Stelle wird bei einer hohen Störsignalunterdrückung zugleich eine besonders einfache Implementierung der Vorrichtung in bestehende Systeme erreicht. Eine Anpassung oder eine Änderung von bestehenden Versorgungsleitungen ist nicht notwendig. Die Versorgungsleitung, auf der eine hohe Leistung transportiert wird, muss zudem nicht über den Verstärker geführt werden. Dies vermindert EMV-Probleme und eine Nachrüstung bestehender Systeme wird stark vereinfacht.

Eine Anwendung der Vorrichtung zur Unterdrückung von Störsignalen bei bipolaren Spannungsquellen kann vor allem zur Störsignalunterdrückung bei Antriebssystemen von Elektrofahrzeugen oder Hybridfahrzeugen erfolgen. Die erfindungsgemäße Vorrichtung kann im Antriebsstrang zwischen einer Batterie oder einem Akku und einer Störquelle eingesetzt werden, um elektromagnetische Störsignale, insbesondere Gleichtaktstörungen bzw. "common mode" Störungen, zu unterdrücken. Unter Gleichtaktstörungen werden Störspannungen und -ströme auf den Verbindungsleitungen zwischen elektrischen Komponenten oder elektrischen Bauelementen verstanden, welche sich mit gleicher Phasenlage und Stromrichtung sowohl auf der Hinleitung als auch der Rückleitung zwischen diesen Komponenten ausbreiten. Solche Störsignale können beispielsweise von einer Störquelle stammen oder durch elektromagnetische Kopplung in die Versorgungsleitungen induziert werden. Um eine hohe Störsignalunterdrückung zu erzielen, wird die erfindungsgemäße Vorrichtung möglichst nahe an der Störquelle installiert. Dies verhindert, dass sich die Störsignale entlang der Versorgungsleitungen ausbreiten und in benachbarte Leitungen einstrahlen.

Die Störquelle kann beispielsweise ein Umrichter oder ein Spannungswandler oder ein Inverter oder ein Fahrtregler eines Elektroantriebs sein.

Bei bipolaren Spannungsquellen werden gleichzeitig eine positive und eine negative Spannung, bezogen auf ein gemeinsames Massepotential, bereitgestellt. Es kann insbesondere vorgesehen sein, dass die Vorrichtung zur Unterdrückung von Störsignalen für symmetrische Spannungsquellen ausgebildet ist. Bei symmetrischen Spannungsquellen ist der Betrag der positiven und der negativen Spannung gleich groß. Vorzugsweise umfassen bipolare oder symmetrische Hochvoltspannungsquellen Spannungen mit ≥ 50 V Gleichspannung, vorzugsweise ≥ 100 V Gleichspannung. Es kann vorgesehen sein, dass die bipolaren Versorgungsleitungen jeweils eine Spannung von größer gleich 50 Volt, vorzugsweise größer gleich 100 Volt, höchst vorzugsweise größer gleich 200 Volt, aufweisen. Vorzugsweise kann die bipolare Spannungsquelle eine symmetrische Spannungsquelle sein und die symmetrischen Spannungsquellen jeweils eine Spannung von größer ± 50 Volt, vorzugsweise größer gleich ± 100 Volt, höchst vorzugsweise größer gleich ±200 Volt, aufweisen. Vorzugsweise kann der Spannungsbereich der Vorrichtung zwischen 50 Volt und 1000 Volt liegen.

Insbesondere weist die Verstärkerschaltung einen aktiven Filter mit diskreten Halbleitern, vorzugsweise Transistoren, auf. Durch die Verwendung eines aktiven Filters fallen die Komponenten der Vorrichtung deutlich kleiner und auch billiger aus, im Vergleich zu einem passiven Filter für denselben Frequenzbereich bzw. Leistungsbereich. Die Verwendung diskreter Halbleiter gewährleistet zudem eine geringe Signallaufzeit.

Die Drossel in der positiven und/oder der negativen Versorgungsleitung zwischen der Stelle des Abgriffs des Störsignal und der Spannungsquelle kann als Spule oder als Ferritkern ausgebildet sein, um in den Zuleitungen der Versorgungsleitungen die Induktivität zu erhöhen. Ferrite sind elektrisch schlecht oder nicht leitende ferrimagnetische keramische Werkstoffe und werden bei Drosseln eingesetzt, um den induktiven Widerstand der Leitungen zu erhöhen. Dies dient zur Begrenzung von Strömen in den Versorgungsleitungen in Richtung der Spannungsquelle und bewirkt, dass die Wirkung der Vorrichtung zur Unterdrückung von Störsignalen auf die Störquelle konzentriert wird.

Unter Abgriff des Störsignales und der Einspeisung des Korrektursignals an derselben Stelle einer Versorgungsleitung versteht man, dass der Abgriff des Störsignals sowie die Einspeisung des Korrektursignals am selben Potential erfolgt, vorzugsweise über denselben Anschlusspunkt erfolgt. Insbesondere ist bei einer Nachrüstung der erfindungsgemäßen Vorrichtung keine Unterbrechung oder Neuverlegung einer vorhandenen Versorgungsleitung notwendig. Es ist jedoch auch möglich, dass der Abgriff des Störsignales und/oder die Einspeisung des Korrektursignales über zwei oder mehr separate Leitungen bzw. zwei oder mehr separate Steckkontakte erfolgt, die elektrisch parallel geschaltet sind und dieselbe Stelle kontaktieren.

Es kann vorgesehen sein, dass die Stelle des Abgriffs des Störsignals mit einer Störquelle über die Versorgungsleitung direkt verbunden ist. Direkt verbunden bedeutet, dass die Verbindung ohne ein zusätzliches Bauteil erfolgt, insbesondere ohne erhöhte Induktivität. Vorzugsweise sind Verbindungen mit kleinem Ohm'schen Widerstand vorgesehen. Vorzugsweise ist an dem Abgriffspunkt die Impedanz in Richtung der Spannungsquelle größer als die Impedanz in Richtung der Störquelle. Die Impedanz setzt sich hier aus dem Wechselstromwiderstand und dem Ohm'schen Widerstand zusammen. Das Verhältnis der Impedanz in Richtung der Spannungsquelle zur Impedanz in Richtung der Störquelle kann vorzugsweise größer 5:1 sein, höchst vorzugsweise größer 10:1 oder im idealen Fall größer 20:1. Das bedeutet, dass die Impedanz in Richtung der Spannungsquelle mindestens der 5 fachen Impedanz zur Störquelle entspricht, höchst vorzugsweise mindestens der 10 fachen oder im idealen Fall mindestens der 20 fachen Impedanz zur Störquelle entspricht. Zur Änderung des Verhältnisses der Impedanz ist die oben beschriebene Drossel in der Zuleitung der Versorgungsleitung in Richtung der Spannungsquelle angeordnet. Durch die Erhöhung der Induktivität in der Versorgungsleitung in Richtung der Spannungsquelle durch die Drossel erhöht sich die Impedanz in Richtung der Spannungsquelle. Die mögliche Leitungslänge in Richtung der Spannungsquelle und Störquelle bestimmt sich durch das Verhältnis der Impedanzen. Vorzugsweise ist die Länge der Versorgungsleitung von der Stelle des Abgriffs des Störsignals bis zu der Störquelle kleiner als 4 m. Es sind aber auch Ausführungen mit längeren Versorgungsleitungen möglich. Direkt verbunden bedeutet, dass die Verbindung ohne ein zusätzliches Bauteil erfolgt, insbesondere ohne erhöhte Induktivität. Vorzugsweise sind Verbindungen mit kleinem Ohm'schen Widerstand vorgesehen.

Um bei dem Abgriff des Sensorsignales und der Einspeisung des Korrektursignales an derselben Stelle eine hohe Störsignalunterdrückung zu erzielen ist vorzugsweise vorgesehen, dass der Verstärker eine kleine Signallaufzeit aufweist. Dadurch werden Phasenverschiebungen zwischen dem Störsignal und dem Korrektursignal minimiert. Auf diese Weise können insbesondere auch transiente oder stochastische Störungen sehr gut unterdrückt werden. Übliche aktive Filter weisen eine entsprechend lange Einschwingzeit auf und sind zur Unterdrückung von transienten oder stochastischen Störungen nicht geeignet. Es kann insbesondere vorgesehen sein, dass die Verstärkerschaltung eine Signallaufzeit zwischen Eingang und Ausgang aufweist, die kleiner gleich 20ns, vorzugsweise kleiner gleich 10ns, höchst vorzugsweise kleiner gleich 6ns, ist. Dadurch ist eine gute Unterdrückung von Störsignalen bis in einen hohen Frequenzbereich, vorzugsweise bis 4 MHz und darüber möglich. Der Frequenzbereich mit der besten Störsignalunterdrückung kann vorzugsweise zwischen 1 Hz und 10MHz liegen, höchst vorzugsweise zwischen 100kHz und 4MHz liegen.

Es kann in einer Ausgestaltung vorgesehen sein, dass die Vorstufe als einstufiger oder zweistufiger Verstärker aufgebaut ist. Vorzugsweise kann vorgesehen sein, dass die Vorstufe einen Tiefpass oder Bandpass bildet. Der Verstärker kann als aktiver Filter mit diskreten Halbleitern, vorzugsweise Transistoren und/oder Feldeffekttransistoren aufgebaut sein. Der Bandpass, vorzugsweise durch RC-Glieder oder LC-Glieder im Übertragungsweg, beschränkt nach unten (niedrige Frequenzen) die Nutzfrequenz der Vorrichtung und verhindert nach oben (höhere Frequenzen) die Schwingungsneigungen des Verstärkers, indem die Verstärkung in hohen Frequenzbereich abgesenkt wird.

Es kann vorgesehen sein, dass die Endstufe als Gegentaktendstufe und/oder als Stromspiegel ausgebildet ist.

Zur Erhöhung des Ausgangsstromes kann vorgesehen sein, dass die Endstufe kaskadierbar ist bzw. dass die Vorstufe mehrere kaskadierbare Endstufen ansteuert. Insbesondere kann vorgesehen sein, dass die Vorstufe zwei kaskadierte Endstufen oder bis zu acht kaskadierte Endstufen ansteuert.

In einer kostengünstig herzustellenden Ausgestaltung kann vorgesehen sein, dass die Vorstufe und die Endstufe aus diskreten Halbleitern, vorzugsweise aus Transistoren und/oder Feldeffekttransistoren ausgebildet sind. Vorzugsweise kann vorgesehen sein, dass die Vorstufe und die Endstufe den gleichen Typ Halbleiter aufweisen.

Insbesondere kann vorgesehen sein, dass die Spannungsquelle eine Batterie oder einen aufladbaren Akku, insbesondere eine Traktionsbatterie, aufweist und einen Elektromotor mit elektrischer Energie versorgt, vorzugsweise einen Elektromotor in einem Fahrzeug mit elektrischer Energie versorgt.

Es kann vorgesehen sein, dass die Drossel einen Ferritkörper aufweist und die positive und/oder negative Versorgungsleitung durch den Ferritkörper hindurchgeführt ist. Ferrite sind elektrisch schlecht oder nicht leitende ferrimagnetische keramische Werkstoffe und werden bei Drosseln eingesetzt, um den induktive Widerstand der Leitungen zu erhöhen.

Vorzugsweise kann vorgesehen sein, dass die Drossel (CMC, oder common mode choke) mehrere Wicklungen der beiden Versorgungsleitungen aufweist, welche gegensinnig vom Strom durchflossen werden.

Es kann vorgesehen sein, dass die galvanische Trennung, der Abgriff des Störsignals von einer Versorgungsleitung, über einen Kondensator, vorzugsweise einen SMD-Kondensator, erfolgt. Es kann vorgesehen sein, dass die Ausgangskondensatoren als SMD-Kondensatoren ausgebildet sind. SMD-Kondensatoren (surface-mount device-Kondensatoren) werden mittels lötfähigen Anschlussflächen direkt auf eine Leiterplatte gelötet. Die Bestückungslöcher in der Leiterplatte entfallen dadurch, wodurch eine dichte Bestückung sowie eine beidseitige Bestückung der Leiterplatte möglich ist. Vorzugsweise können zur galvanischen Trennung und/oder als Ausgangskondensatoren hochspannungsfeste SMD-Kondensatoren verwendet werden, wobei die SMD-Kondensatoren für eine Spannung oberhalb der Spannung der Spannungsquelle ausgelegt sind.

Die galvanische Trennung bewirkt, dass der Verstärker auf einem anderen, insbesondere einem niedrigeren Spannungsniveau betrieben werden kann als die Versorgungsleitungen der Spannungsquelle. Insbesondere ist das Spannungsniveau des Verstärkers deutlich kleiner als das der Hochspannungsquelle, vorzugsweise mit einem Faktor 4 oder größer. Der Vorteil dabei ist, dass kostengünstigere Halbleiter verwendet werden können bzw. können Störungen eines höheren Spannungsniveaus gefiltert werden. Der Betrieb der Verstärkerschaltung auf einem niedrigeren Spannungsniveau ermöglicht zudem einen konstruktiv einfacheren Aufbau, da es möglich ist auf einem solchen Spannungsniveau zu arbeiten, sodass die verschärften Vorschriften zur Hochvoltsicherheit auf die Verstärkerschaltung nicht zutreffen.

Es kann in einer vorzugsweisen Ausgestaltung vorgesehen sein, dass die Ausgangskondensatoren jeweils mehrere parallel geschaltete Kondensatoren aufweisen. Durch die Parallelschaltung der Ausgangskondensatoren werden parasitäre Induktivitäten verringert, wodurch die Laufzeit in der Vorrichtung verringert wird, die Signaltreue in der Vorrichtung verbessert wird und störende Spannungsschwingungen unterdrückt werden.

Es kann vorgesehen sein, dass der Verstärker bzw. dass die Vorstufe und die Endstufe eine symmetrische Spannungsversorgung aufweisen, vorzugsweise eine gemeinsame symmetrische Spannungsversorgung aufweisen. Die Spannungsversorgung des Verstärkers bzw. der Vorstufe und/oder der Endstufe kann beispielsweise aus der positiven und der negativen Versorgungsleitung abgeleitet sein. Es kann vorgesehen sein, durch einen Spannungswandler eine Versorgungsspannung, vorzugsweise von ±12 V, aus der Hochvoltquelle abzuleiten. Durch das Ableiten der Versorgungsspannung aus der Hochvoltquelle ergibt sich der Vorteil, dass durch Kontaktieren der Vorrichtung in den Versorgungsleitungen gleichzeitig eine Spannungsversorgung für die Verstärker aufgebaut wird.

In einer alternativen Ausgestaltung kann die Spannungsversorgung des Verstärkers bzw. der Vorstufe und/oder der Endstufe aus einer separaten

Niederspannungsquelle, beispielsweise aus der 12V Spannungsquelle eines Fahrzeugs abgeleitet sein.

Um eine kompakte Baugröße zu erzielen kann ein Spannungswandler, der eine Spannung aus der positiven und der negativen Versorgungsleitung oder aus einer separaten Niederspannungsquelle ableitet, räumlich bei dem Verstärker angeordnet sein, beispielsweise auf derselben Platine angeordnet sein.

Es kann vorgesehen sein, dass die Verstärkerschaltung mit der Vorstufe und der Endstufe und den Ausgangskondensatoren auf einer einzigen Platine oder einem einzigen PCB Board angeordnet ist. Dadurch wird eine kleine Baugröße erzielt und es ist eine schnelle und einfache Montage der Platine möglich. Ein PCB Board (printed circuit board) ist eine Leiterplatte oder eine Platine, auf der die elektronischen Bauteile angeordnet sind, und dient zur Befestigung der Bauteile und zur elektrischen Verbindung der Bauteile.

Es kann vorgesehen sein, dass die Platine oder das PCB Board zwei Kontaktierzonen zum elektrischen Anschluss an die Versorgungsleitungen aufweist, wobei die erste Kontaktierzone zum Anschluss an die positive Versorgungsleitung und die zweite Kontaktierzone zum Anschluss an die negative Versorgungsleitung ausgebildet ist.

Insbesondere kann vorgesehen sein, dass die Platine eine Aussparung aufweist, die von einer der Kontaktierzonen zumindest teilweise umrandet ist und der elektrische Anschluss an eine Versorgungsleitung erfolgt, indem ein Raststift oder eine Schraube in die Aussparung eingreift oder die Aussparung durchgreift, um die Kontaktierzone elektrisch leitend mit der Versorgungsleitung zu verbinden.

Die Aufgabe der Erfindung wird weiter gelöst durch ein Entstörmodul zum Nachrüsten für bipolare oder symmetrische Spannungsquellen, insbesondere Hochvoltspannungsquellen in einem Antriebsstrang eines Elektrofahrzeugs, umfassend ein Gehäuse, in dem eine Verstärkerschaltung einer erfindungsgemäße Vorrichtung aufgenommen ist.

Durch ein solches Entstörmodul kann die Vorrichtung zur Unterdrückung von Störsignalen einfach und sicher in einem Elektrofahrzeug installiert werden.

Es kann vorgesehen sein, dass die Drossel außerhalb des Gehäuses in der positiven Versorgungsleitung und der negativen Versorgungsleitung jeweils zwischen der Stelle des Abgriffs des Störsignals und der Spannungsquelle angeordnet ist.

Dabei kann vorgesehen sein, dass das Gehäuse Verbindungsmittel zum mechanischen und/oder elektrischen Verbinden der Verstärkerschaltung mit den Versorgungsleitungen der Spannungsquelle umfasst.

Es kann vorgesehen sein, dass die Störquelle ein Gehäuse mit einem Bauraum oder einem Aufnahmeraum zur Aufnahme der Platine oder des Entstörmoduls aufweist, wobei die Platine oder das Entstörmodul in dem Bauraum bzw. Aufnahmeraum aufgenommen und mit dem Gehäuse der Störquelle mechanisch verbunden ist.

Die Aufgabe der Erfindung wird weiter gelöst durch ein Verfahren zum Entstören einer bipolaren oder symmetrischen Spannungsquelle, welche eine positive Versorgungsleitung und eine negative Versorgungsleitung umfasst, wobei eine erfindungsgemäße Vorrichtung verwendet wird und sowohl von der positiven Versorgungsleitung als auch von der negativen Versorgungsleitung eine elektrische Verbindung mit einer Elektrode der Vorrichtung hergestellt wird.

Es kann vorgesehen sein, dass die elektrische Verbindung durch eine Steckverbindung oder eine Schraubverbindung hergestellt wird, vorzugsweise in einem Arbeitsschritt zugleich mit der mechanischen Befestigung der Platine oder des Entstörmoduls hergestellt wird.

Es kann vorgesehen sein, dass auf der positiven und auf der negativen Versorgungsleitung jeweils ein klappbarer Ferritkern derart angebracht wird, dass dieser an der Versorgungsleitung zwischen einer Batterie oder einem aufladbaren Akku einerseits und dem Anschluss der Vorrichtung andererseits angeordnet ist. Eine Anwendung der Erfindung kann beispielsweise zur Störsignalunterdrückung im Antriebsstrang bei elektrischen Fahrzeugen erfolgen. Generell kann die Erfindung zur Störsignalunterdrückung bei elektrischen Antrieben höherer Leistung zum Einsatz kommen, also beispielsweise auch bei stationären Elektromotoren wie sie bei Klimaanlagen verwendet werden. Dabei kann die Erfindung bereits bei der Konstruktion neuer Anlagen berücksichtigt werden und zum Einsatz kommen. Aber auch bei einer Nachrüstung oder Umrüstung bestehender Anlagen kann die Erfindung bestehende Filteranordnungen ergänzen oder ersetzen.

In den Figuren sind Ausführungsbeispiele der Erfindung dargestellt und nachfolgend erläutert. Dabei zeigen:
- Fig. 1: Schaltungsanordnung der erfindungsgemäßen Vorrichtung zur Unterdrückung von Störsignalen;
- Fig. 2: Darstellung eines schematischen Schaltungsbeispiels einer Verstärkerschaltung der erfindungsgemäßen Vorrichtung zur Unterdrückung von Störsignalen;
- Fig. 3: ein Beispiel einer Schaltung der erfindungsgemäßen Vorrichtung zur Unterdrückung von Störsignalen aus Fig. 2.

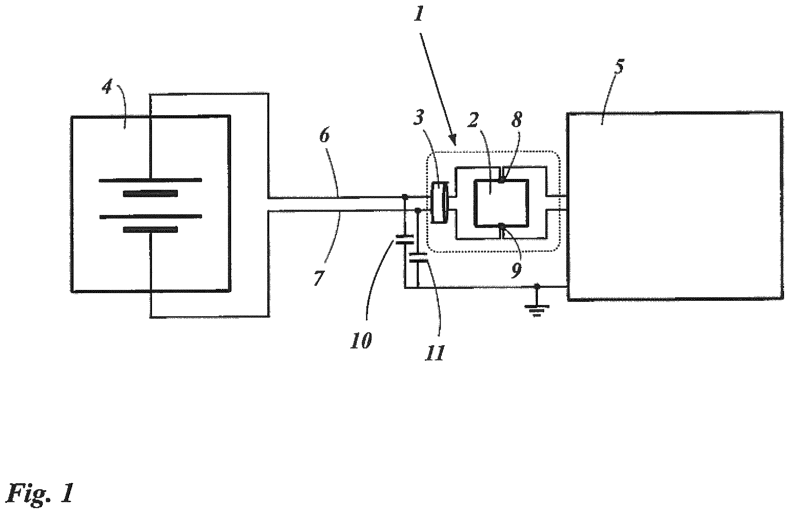

Figur 1 zeigt eine Schaltungsanordnung mit einer bipolaren Hochspannungsquelle 4, einem Frequenzumrichter 5 und einer Vorrichtung 1 zur Unterdrückung von Störsignalen. Die Vorrichtung 1 weist eine Verstärkerschaltung 2 und eine Drossel 3 auf und ist zwischen der Hochspannungsquelle 4 und dem Frequenzumrichter 5 angeordnet.

Die Verstärkerschaltung 2 kontaktiert die Versorgungsleitungen 6 und 7 jeweils an nur einem Punkt. Ein erster Punkt 8 ist mit der positiven Versorgungsleitung 6 verbunden. An einem zweiten Punkt 9 ist die Verstärkerschaltung 2 mit der negativen Versorgungsleitung 7 verbunden. Der Signalabgriff eines Störsignals und die Signaleinspeisung des von der Verstärkerschaltung gebildeten Korrektursignals erfolgt dadurch an derselben Stelle an der positiven Versorgungsleitung 6 bzw. der negativen Versorgungsleitung 7. Die Verstärkerschaltung 2 ist zwischen dem Frequenzumrichter 5 und der Drossel 3 angeordnet.

Die in der Figur 1 gezeigten y-Kondensatoren 10 und 11 sind optional in der Schaltung angeordnet und dienen einer verbesserten Unterdrückung von Störsignalen.

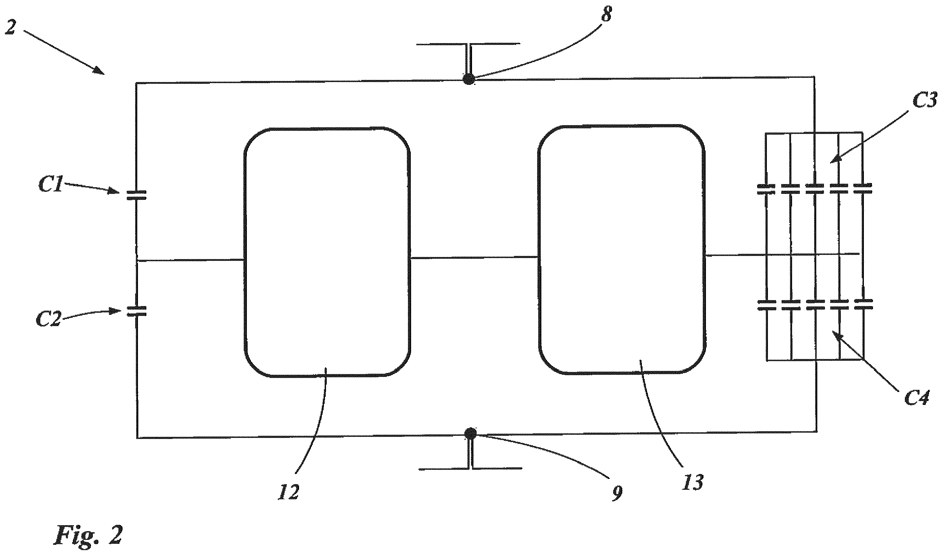

In Figur 2 ist eine beispielhafte Verstärkerschaltung 2 schematisch dargestellt. Wie oben beschrieben, ist die Verstärkerschaltung 2 nur an einem ersten Punkt 8 mit der positiven Versorgungsleitung 6 verbunden und an einem zweiten Punkt 9 mit der negativen Versorgungsleitung verbunden. Die Verstärkerschaltung 2 weist eine Vorstufe 12 und eine Endstufe 13 auf, die durch die Kondensatoren C1 bis C4 galvanisch von den Versorgungsleitungen 6 und 7 getrennt sind.

Das aus den Versorgungsleitungen 6 und 7 abgegriffene Störsignal wird in der Verstärkerschaltung 2 verstärkt und von der Endstufe mit entgegengesetzter Polarität als Korrektursignal wieder in die Versorgungsleitungen 6 und 7 an den Punkten 8 und 9 eingespeist. Die Einspeisung des von der Endstufe gelieferten Korrektursignales erfolgt direkt in die beiden Versorgungsleitungen 6 und 7.

Wie in der Figur 2 gezeigt, ist der Ausgang der Endstufe 13, über den ein Korrektursignal in die Versorgungsleitungen 6 und 7 eingespeist wird, über mehrere Kondensatoren C3 und C4 symmetrisch mit der positiven Versorgungsleitung 6 und der negativen Versorgungsleitung 7 verbunden. In dem erfindungsgemäßen Ausführungsbeispiel der Figur 2 sind jeweils fünf Kondensatoren C3 parallel geschalten und fünf Kondensatoren C4 parallel geschalten. Durch die Parallelschaltung der jeweils fünf Ausgangskondensatoren C3 und C4 werden parasitäre Induktivitäten verringert, wodurch die Laufzeit in der Verstärkerschaltung 2 verringert wird, die Signaltreue in der Verstärkerschaltung 2 verbessert wird und störende Spannungsschwingungen unterdrückt werden.

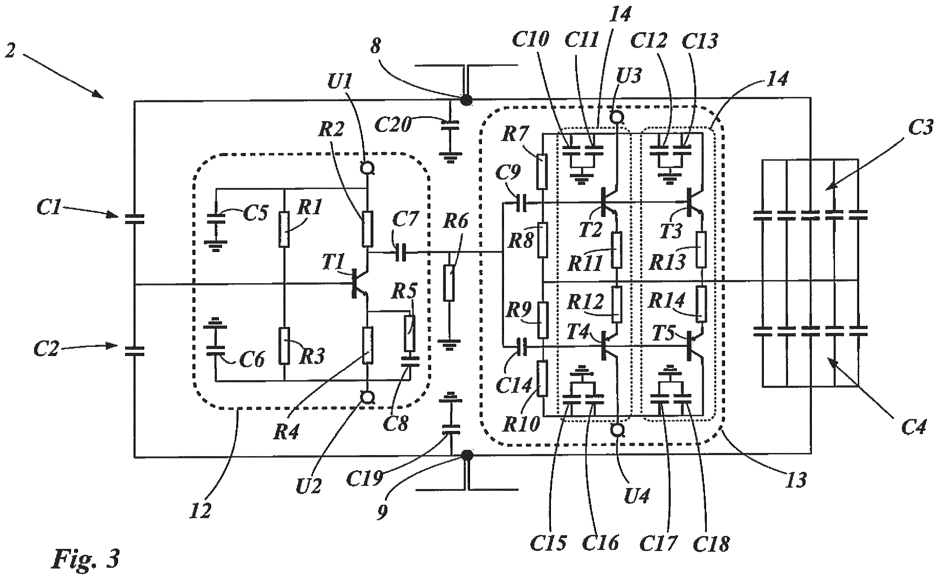

In der Figur 3 ist die Verstärkerschaltung 2 aus Figur 2 im Detail in einem Schaltdiagramm dargestellt. Sie umfasst die Vorstufe 12 und die Endstufe 13.

Die Vorstufe 12 weist einen Transistor T1 in Emitterschaltung auf. Über die Widerstände R1 und R3 wird der Arbeitspunkt an der Basis des Transistors T1 eingestellt. Die Kondensatoren C5 und C6 entkoppeln die Emitterschaltung gegen Masse. Durch eine symmetrische Niederspannungsquelle U1 und U2 wird an dem Transistor T1 eine Spannung von ±12V angelegt. Der Kollektorkreis wird über einen Kollektorwiderstand R2 und einen Auskoppelkondensator C7 gebildet. Der Emitterkreis weist die Widerstände R4 und R5 und den Kondensator C5 als frequenzabhängiges Glied auf. Der Kondensator C7 auf der Kollektorseite des Transistors T1 wirkt als Ausgangskondensator der Vorstufe 12 zur Entkopplung der Vorstufe 12 und der Endstufe 13. Zwischen dem Ausgang der Vorstufe 12 und dem Eingang der Endstufe 13 ist ein Widerstand R6 gegen Masse angeordnet.

Die Endstufe 13 ist über die Eingangskondensatoren C9 und C14 mit der Vorstufe 12 verbunden. Die Endstufe weist zwei kaskadierte Gegentaktendstufen auf. Die beiden Transistoren T4 und T2 bilden die erste Gegentaktendstufe und die beiden Transistoren T5 und T3 bilden die zweite Gegentaktendstufe. Die Widerstände R7 bis R14 stellen die Arbeitspunkte an der Basis der Transistoren T2 bis T5 ein. Die Transistoren T2 und T3 sind als npn-Transistoren ausgebildet und die Transistoren T4 und T5 sind als komplementäre pnp-Transistoren ausgebildet. Die Widerstände R11 und R12 bzw. R13 und R14 dienen zur Symmetrierung bzw. zur Strombegrenzung im Ausgangskreis der Gegentaktschaltungen. Die Kondensatoren C10, C11, C15 und C16 sind aus Gründen der Störentkopplung vorgesehen und Entkoppeln die Spannungsversorgung gegen Masse.

In der Endstufe 13 können bist zu acht Gegentaktendstufen kaskadiert werden, welche mit einer dritten Niederspannungsquelle U3 (+12 V) und einer vierten Niederspannungsquelle U4 (-12 V) verbunden sind.

Der Einfachheit halber können die Vorstufe 12 und die Endstufe 13 aus derselben symmetrischen Niederspannungsquelle gespeist werden. In diesem Fall ist U1 gleich U3 sowie U2 gleich U4. Alternativ können für die Vorstufe 12 und die Endstufe 13 jeweils eigene symmetrische Niederspannungsquellen U1, U2 bzw. U3, U4 verwendet werden.

Die symmetrische Niederspannungsquelle U1, U2 bzw. U3, U4 kann über einen Spannungswandler aus der Hochvoltspannungsquelle gespeist sein. Alternativ kann die Niederspannungsquelle U1, U2 bzw. U3, U4 aus einem separaten Netz, beispielsweise einem 12V oder 24V Bordnetz eines Fahrzeugs gespeist werden.

### Bezugszeichenliste

- 1: Vorrichtung zur Unterdrückung von Störsignalen
- 2: Verstärkerschaltung
- 3: Drossel
- 4: Hochspannungsquelle
- 5: Frequenzumrichter
- 6: positive Versorgungsleitung
- 7: negative Versorgungsleitung
- 8: erster Verbindungspunkt
- 9: zweiter Verbindungspunkt
- 10: erster y-Kondensator
- 11: zweiter y-Kondensator
- 12: Vorstufe
- 13: Endstufe
- 14: Gegentaktendstufe
- C1 bis C18: Kondensator
- R1 bis R14: Widerstand
- T1 bis T5: Transistor
- U1: erste Niederspannungsquelle
- U2: zweite Niederspannungsquelle
- U3: dritte Niederspannungsquelle
- U4: vierte Niederspannungsquelle

## Patentansprüche

1. Vorrichtung (1) zur Unterdrückung von Störsignalen für bipolare Spannungsquellen (4), insbesondere für Hochvoltspannungsquellen in einem Antriebsstrang eines Elektrofahrzeugs,
umfassend eine positive Versorgungsleitung (6) und eine negative Versorgungsleitung (7) einer Spannungsquelle (4) und eine Verstärkerschaltung (2) mit einer Vorstufe (12), deren Eingang mittels eines galvanisch getrennten Abgriffs symmetrisch mit der positiven Versorgungsleitung (6) und der negativen Versorgungsleitung (7) der Spannungsquelle (4) verbunden ist, um ein Störsignal abzugreifen,
und mit einer von der Vorstufe (12) angesteuerten Endstufe (13), deren Ausgang über jeweils einen Ausgangskondensator (C3, C4) mit der positiven Versorgungsleitung (6) und der negativen Versorgungsleitung (7) symmetrisch verbunden ist, um ein Korrektursignal einzuspeisen,
**dadurch gekennzeichnet,**
**dass** die positive Versorgungsleitung (6) und die negative Versorgungsleitung (7) jeweils zwischen der Stelle des Abgriffs des Störsignals und der Spannungsquelle (4) entweder eine Drossel (3) aufweist, und/oder eine höhere Impedanz als zwischen der Stelle des Abgriffs des Störsignals und einer Störquelle (5) aufweist, und wobei der Abgriff des Störsignals und die Einspeisung des Korrektursignals jeweils an derselben Stelle einer Versorgungsleitung (6, 7) erfolgt.

2. Vorrichtung zur Unterdrückung von Störsignalen nach Anspruch 1,
**dadurch gekennzeichnet,**
**dass** die Stelle des Abgriffs des Störsignals mit einer Störquelle (5) über die Versorgungsleitung (6, 7) direkt verbunden ist, vorzugsweise ohne ein zwischengeschaltetes Bauteil verbunden ist.

3. Vorrichtung zur Unterdrückung von Störsignalen nach einem der Ansprüche 1 oder 2,
**dadurch gekennzeichnet,**
**dass** die Verstärkerschaltung (2) eine Signallaufzeit zwischen Eingang und Ausgang aufweist, die kleiner gleich 20ns, vorzugsweise kleiner gleich 10ns, höchst vorzugsweise kleiner gleich 6ns, ist.

4. Vorrichtung zur Unterdrückung von Störsignalen nach einem der Ansprüche 1 bis 3,
**dadurch gekennzeichnet,**
**dass** die Vorstufe (12) als einstufiger oder zweistufiger Verstärker aufgebaut ist, vorzugsweise dass die Vorstufe (12) einen Bandpass bildet, und/oder dass die Endstufe (13) als Gegentaktendstufe (14) und/oder als Stromspiegel ausgebildet ist.

5. Vorrichtung zur Unterdrückung von Störsignalen nach einem der vorhergehenden Ansprüche,
**dadurch gekennzeichnet,**
**dass** die Endstufe (13) kaskadierbar ist und die Vorstufe (12) dazu eingerichtet ist, mehrere kaskadierbare Endstufen (13) anzusteuern, insbesondere zwei kaskadierte Endstufen (13) oder vier kaskadierte Endstufen (13) oder sechs kaskadierte Endstufen (13) oder acht kaskadierte Endstufen (13), anzusteuern.

6. Vorrichtung zur Unterdrückung von Störsignalen nach einem der vorhergehenden Ansprüche,
**dadurch gekennzeichnet,**
**dass** die Vorstufe (12) und die Endstufe (13) aus diskreten Halbleitern, vorzugsweise aus Transistoren (T1 bis T5) und/oder Feldeffekttransistoren ausgebildet sind, vorzugsweise, dass die Vorstufe (12) und die Endstufe (13) den gleichen Typ Halbleiter aufweisen.

7. Vorrichtung zur Unterdrückung von Störsignalen nach einem der vorhergehenden Ansprüche,
**dadurch gekennzeichnet,**
**dass** die Spannungsquelle (4) eine Batterie oder einen aufladbaren Akku, insbesondere eine Traktionsbatterie, aufweist und einen Elektromotor mit elektrischer Energie versorgt, vorzugsweise einen Elektromotor in einem Fahrzeug mit elektrischer Energie versorgt, wobei insbesondere vorgesehen ist,
**dass** die bipolaren Versorgungsleitungen (6, 7) jeweils eine Spannung von größer gleich 50 Volt, vorzugsweise größer gleich 100 Volt, höchst vorzugsweise größer gleich 200 Volt, aufweisen.

8. Vorrichtung zur Unterdrückung von Störsignalen nach einem der vorhergehenden Ansprüche,
**dadurch gekennzeichnet,**
**dass** die Drossel (3) einen Ferritkörper aufweist und die positive und/oder negative Versorgungsleitung (6, 7) durch den Ferritkörper hindurchgeführt ist.

9. Vorrichtung zur Unterdrückung von Störsignalen nach einem der vorhergehenden Ansprüche,
**dadurch gekennzeichnet,**
**dass** die galvanische Trennung, der Abgriff des Störsignals von einer Versorgungsleitung (6, 7), über einen Kondensator (C1, C2), vorzugsweise einen SMD-Kondensator, erfolgt, und/oder
**dass** die Ausgangskondensatoren (C3, C4) als SMD-Kondensatoren ausgebildet sind, wobei vorzugsweise vorgesehen ist,
**dass** die Ausgangskondensatoren (C3, C4) jeweils mehrere parallel geschaltete Kondensatoren (C3, C4) aufweisen.

10. Vorrichtung zur Unterdrückung von Störsignalen nach einem der vorhergehenden Ansprüche,
**dadurch gekennzeichnet,**
**dass** die Vorstufe (12) und die Endstufe (13) eine symmetrische Spannungsversorgung aufweisen, vorzugsweise eine gemeinsame symmetrische Spannungsversorgung aufweisen, die entweder aus der positiven und der negativen Versorgungsleitung (6, 7) abgeleitet ist oder aus einer separaten Niederspannungsquelle abgeleitet ist.

11. Vorrichtung zur Unterdrückung von Störsignalen nach einem der vorhergehenden Ansprüche,
**dadurch gekennzeichnet,**
**dass** die Verstärkerschaltung (2) mit der Vorstufe (12) und der Endstufe (13) und den Ausgangskondensatoren (C3, C4) auf einer einzigen Platine oder einem einzigen PCB Board angeordnet ist, wobei vorzugsweise vorgesehen ist,
**dass** die Platine oder das PCB Board zwei Kontaktierzonen zum elektrischen Anschluss an die Versorgungsleitungen (6, 7) aufweist, wobei die erste Kontaktierzone zum Anschluss an die positive Versorgungsleitung (6) und die zweite Kontaktierzone zum Anschluss an die negative Versorgungsleitung (7) ausgebildet ist, und/oder vorzugsweise vorgesehen ist,
**dass** die Platine eine Aussparung aufweist, die von einer der Kontaktierzonen zumindest teilweise umrandet ist und der elektrische Anschluss an eine Versorgungsleitung (6, 7) erfolgt, indem ein Raststift oder eine Schraube in die Aussparung eingreift oder die Aussparung durchgreift, um die Kontaktierzone elektrisch leitend mit der Versorgungsleitung (6, 7) zu verbinden.

12. Entstörmodul zum Nachrüsten für bipolare Spannungsquellen (4), insbesondere Hochvoltspannungsquellen in einem Antriebsstrang eines Elektrofahrzeugs,
umfassend ein Gehäuse, in dem eine Verstärkerschaltung (2) einer Vorrichtung (1) nach einem der vorhergehenden Ansprüche aufgenommen ist, wobei vorzugsweise vorgesehen ist,
dass das Gehäuse Verbindungsmittel zum mechanischen und/oder elektrischen Verbinden der Verstärkerschaltung (2) mit den Versorgungsleitungen (6, 7) der Spannungsquelle (4) umfasst.

13. Vorrichtung nach einem der vorhergehenden Ansprüche,
**dadurch gekennzeichnet,**
**dass** die Störquelle (5) ein Gehäuse mit einem Bauraum zur Aufnahme der Platine oder des Entstörmoduls aufweist, wobei die Platine oder das Entstörmodul in dem Bauraum aufgenommen und mit dem Gehäuse der Störquelle (5) mechanisch verbunden ist.

14. Verfahren zum Entstören einer bipolaren Spannungsquelle (4), welche eine positive Versorgungsleitung (6) und eine negative Versorgungsleitung (7) umfasst, wobei eine Vorrichtung (1) nach einem der vorhergehenden Ansprüche verwendet wird und sowohl von der positiven Versorgungsleitung (6) als auch von der negativen Versorgungsleitung (7) eine elektrische Verbindung mit einer Elektrode der Vorrichtung (1) hergestellt wird.

15. Verfahren nach Anspruch 14,
**dadurch gekennzeichnet,**
**dass** die elektrische Verbindung durch eine Steckverbindung oder eine Schraubverbindung hergestellt wird, vorzugsweise in einem Arbeitsschritt mit der mechanischen Befestigung der Platine oder des Entstörmoduls hergestellt wird und/oder vorzugsweise vorgesehen ist,
**dass** auf der positiven und auf der negativen Versorgungsleitung (6, 7) jeweils ein klappbarer Ferritkern derart angebracht wird, dass dieser an der Versorgungsleitung zwischen einer Batterie oder einem aufladbaren Akku einerseits und dem Anschluss der Vorrichtung (1) andererseits angeordnet ist.

## Claims

1. Device (1) for suppressing interference signals for bipolar voltage sources (4), in particular for high-voltage sources in a drive train of an electric vehicle, comprising a positive supply line (6) and a negative supply line (7) of a voltage source (4) and an amplifier circuit (2) having a pre-amplifier (12), the input of which is symmetrically connected to the positive supply line (6) and the negative supply line (7) of the voltage source (4) by means of a galvanically isolated tap in order to tap an interference signal, and having a power amplifier (13) controlled by the pre-amplifier (12), the output of which power amplifier is symmetrically connected to the positive supply line (6) and the negative supply line (7) by an output capacitor (C3, C4) in each case in order to feed in a correction signal,
**characterised in that**
the positive supply line (6) and the negative supply line (7) has either a throttle (3) between the position of the tap of the interference signal and the voltage source (4) in each case, and/or has a higher impedance than between the position of the tap of the interference signal and a voltage source (5), and wherein the tap of the interference signal and the feed of the correction signal occurs in the same position of a supply line (6, 7) in each case.

2. Device for suppressing interference signals according to claim 1,
**characterised in that**
the position of the tap of the interference signal is directly connected to an interference source (5) by means of the supply line (6, 7), preferably is connected without an interposed component.

3. Device for suppressing interference signals according to one of claims 1 or 2, **characterised in that**
the amplifier circuit (2) has a signal propagation time between input and output which is less than or equal to 20ns, preferably less than or equal to 10ns, most preferably less than or equal to 6ns.

4. Device for suppressing interference signals according to one of claims 1 to 3, **characterised in that**
the pre-amplifier (12) is constructed as a single-stage or double-stage amplifier, preferably the pre-amplifier (12) forms a bandpass, and/or the power amplifier (13) is formed as a push-pull power amplifier (14) and/or a current mirror.

5. Device for suppressing interference signals according to one of the preceding claims, **characterised in that**
the power amplifier (13) is cascadable and the pre-amplifier (12) is set up to control multiple cascadable power amplifiers (13), in particular two cascaded power amplifiers (13) or four cascaded power amplifiers (13) or six cascaded power amplifiers (13) or eight cascaded power amplifiers (13).

6. Device for suppressing interference signals according to one of the preceding claims, **characterised in that**
the pre-amplifier (12) and the power amplifier (13) are formed from discrete semiconductors, preferably from transistors (T1 to T5) and/or field-effect transistors, preferably, the pre-amplifier (12) and the power amplifier (13) have the same type of semi-conductor.

7. Device for suppressing interference signals according to one of the preceding claims, **characterised in that**
the voltage source (4) has a battery or a rechargeable accumulator, in particular a traction battery, and supplies an electric motor with electrical energy, preferably supplies an electric motor in a vehicle with electrical energy, wherein it is in particular provided that
the bipolar supply lines (6, 7) each have a voltage of greater than or equal to 50 Volts, preferably greater than or equal to 100 Volts, most preferably greater than or equal to 200 Volts.

8. Device for suppressing interference signals according to one of the preceding claims, **characterised in that**
the throttle (3) has a ferrite body and the positive and/or negative supply line (6, 7) is guided through the ferrite body.

9. Device for suppressing interference signals according to one of the preceding claims, **characterised in that**
the galvanic isolation, the tap of the interference signal from a supply line (6, 7), occurs via a capacitor (C1, C2), preferably an SMD capacitor, and/or
the output capacitors (C3, C4) are formed as SMD capacitors, wherein it is preferably provided that
the output capacitors (C3, C4) each have multiple capacitors (C3, C4) connected in parallel.

10. Device for suppressing interference signals according to one of the preceding claims, **characterised in that**
the pre-amplifier (12) and the power amplifier (13) have a symmetrical voltage supply, preferably a common symmetrical voltage supply, which is either derived from the positive and the negative supply line (6, 7) or from a separate low voltage source.

11. Device for suppressing interference signals according to one of the preceding claims, **characterised in that**
the amplifier circuit (2) is arranged with the pre-amplifier (12) and the power amplifier (13) and the output capacitors (C3, C4) on a single board or a single PCB board, wherein it is preferably provided that
the board or the PCB board has two contacting zones for electrically connecting to the supply lines (6, 7), wherein the first contacting zone is designed to connect to the positive supply line (6) and the second contacting zone is designed to connect to the negative supply line (7), and/or it is preferably provided that the board has a recess which is surrounded at least partially by one of the contacting zones, and the electrical connection to a supply line (6, 7) occurs by a plunger pin or a screw engaging in the recess or engaging through the recess in order to connect the contacting zone to the supply line (6, 7) in an electrically conductive manner.

12. Interference suppression module for retrofitting bipolar voltage sources (4),
in particular high-voltage sources in a drive train of an electric vehicle,
comprising a housing, in which an amplifier circuit (2) of a device (1) according to one of the preceding claims is accommodated, wherein it is preferably provided that the housing comprises connecting means for mechanically and/or electrically connecting the amplifier circuit (2) to the supply lines (6, 7) of the voltage source (4).

13. Device according to one of the preceding claims,
**characterised in that**
the interference source (5) has a housing having an installation space for accommodating the board or the interference suppression module, wherein the board or the interference suppression module is accommodated in the installation space and is mechanically connected to the housing of the interference source (5).

14. Method for the interference suppression of a bipolar voltage source (4), which comprises a positive supply line (6) and a negative supply line (7), wherein a device (1) according to one of the preceding claims is used, and an electric connection is produced from both the positive supply line (6) and from the negative supply line (7) to an electrode of the device (1).

15. Method according to claim 14,
**characterised in that**
the electrical connection is produced by a plug connection or a screw connection, preferably is produced with the mechanical fastening of the board or the interference suppression module in a working step, and/or it is preferably provided that a foldable ferrite core is applied on the positive and negative supply line (6, 7) in each case in such a way that it is arranged on the supply line between a battery or a chargeable accumulator on the one side and the connector of the device (1) on the other side.

## Revendications

1. Dispositif (1) pour l'inhibition de signaux parasites pour des sources de tension bipolaires (4), plus particulièrement pour des sources de haute tension dans un groupe motopropulseur d'un véhicule électrique,
comprenant une ligne d'alimentation positive (6) et une ligne d'alimentation négative (7) d'une source de tension (4) et un circuit amplificateur (2) avec un étage de préamplification (12) dont l'entrée est reliée au moyen d'une prise isolée galvaniquement de manière symétrique avec la ligne d'alimentation positive (6) et la ligne d'alimentation négative (7) de la source de tension (4), afin de prélever un signal parasite, et avec un étage final (13) contrôlé par l'étage de préamplification (12), dont la sortie est reliée, par l'intermédiaire respectivement d'un condensateur de sortie (C3, C4), de manière symétrique avec la ligne d'alimentation positive (6) et la ligne d'alimentation négative (7), afin d'introduire un signal de correction,
**caractérisé en ce que**
la ligne d'alimentation positive (6) et la ligne d'alimentation négative (7) comprennent respectivement, entre l'emplacement de la prise du signal parasite et la source de tension (4), soit une inductance (3) et/ou une impédance plus grande qu'entre l'emplacement de la prise du signal parasite et une source de signaux parasite (5) et dans lequel le prélèvement du signal parasite et l'introduction du signal de correction ont lieu respectivement au même endroit d'une ligne d'alimentation (6, 7).

2. Dispositif pour l'inhibition de signaux parasites selon la revendication 1, **caractérisé en ce que**
l'emplacement de la prise du signal parasite est relié directement avec une source de signaux parasites (5) par l'intermédiaire de la ligne d'alimentation (6, 7), de préférence sans composant intercalé.

3. Dispositif pour l'inhibition de signaux parasites selon l'une des revendications 1 ou 2,
**caractérisé en ce que**
le circuit amplificateur (2) présente un temps de propagation de signal entre l'entrée et la sortie qui est inférieure ou égal à 20 ns, de préférence inférieur ou égal à 10 ns, de préférence inférieur ou égal à 6 ns.

4. Dispositif pour l'inhibition de signaux parasites selon l'une des revendications 1 à 3,
**caractérisé en ce que**
l'étage de préamplification (12) est conçu comme un amplificateur à un étage ou à deux étages, de préférence **en ce que** l'étage de préamplification (12) constitue un passe-bande et/ou **en ce que** l'étage final (13) est conçu comme un étage final en opposition (14) et/ou comme un miroir de courant.

5. Dispositif pour l'inhibition de signaux parasites selon l'une des revendications précédentes,
**caractérisé en ce que**
l'étage final (13) peut être connecté en cascade et l'étage de préamplification (12) est conçu pour contrôler plusieurs étages finaux (13) connectés en cascade, plus particulièrement pour contrôler deux étages finaux (13) connectés en cascade ou quatre étages finaux (13) connectés en cascade ou six étages finaux (13) connectés en cascade ou huit étages finaux (13) connectés en cascade.

6. Dispositif pour l'inhibition de signaux parasites selon l'une des revendications précédentes,
**caractérisé en ce que**
l'étage de préamplification (12) et l'étage final (13) sont constitués de semiconducteurs discrets, de préférence de transistors (T1 à T5) et/ou de transistors à effet de champ, de préférence **en ce que** l'étage de préamplification (12) et l'étage final (13) présentent le même type de semi-conducteur.

7. Dispositif pour l'inhibition de signaux parasites selon l'une des revendications précédentes,
**caractérisé en ce que**
la source de tension (4) comprend une batterie ou un accumulateur rechargeable, plus particulièrement une batterie de traction et alimente un moteur électrique en énergie électrique, de préférence alimente un moteur électrique d'un véhicule en énergie électrique, dans lequel, plus particulièrement, il est prévu
que les lignes d'alimentation bipolaires (6, 7) présentent respectivement une tension supérieure ou égale à 50 volts, de préférence supérieure ou égale à 100 volts, de préférence supérieure ou égale à 200 volts.

8. Dispositif pour l'inhibition de signaux parasites selon l'une des revendications précédentes,
**caractérisé en ce que**
l'inductance (3) comprend un corps en ferrite et les lignes d'alimentation positive et/ou négative (6, 7) sont guidées à travers le corps en ferrite.

9. Dispositif pour l'inhibition de signaux parasites selon l'une des revendications précédentes,
**caractérisé en ce que**
l'isolation galvanique et la prise du signal parasite sont réalisées par une ligne d'alimentation (6, 7), par l'intermédiaire d'un condensateur (C1, C2), de préférence un condensateur SMD et/ou
les condensateurs de sortie (C3, C4) sont conçus comme des condensateurs SMD, dans lequel de préférence il est prévu
que les condensateurs de sortie (C3, C4) comprennent respectivement plusieurs condensateurs (C3, C4) connectés en parallèle.

10. Dispositif pour l'inhibition de signaux parasites selon l'une des revendications précédentes,
**caractérisé en ce que**
l'étage de préamplification (12) et l'étage final (13) comprennent une alimentation en tension symétrique, de préférence une alimentation en tension symétrique commune, qui est dérivée soit des lignes d'alimentation positive et négative (6, 7), soit d'une source de basse tension.

11. Dispositif pour l'inhibition de signaux parasites selon l'une des revendications précédentes,
**caractérisé en ce que**
le circuit amplificateur (2) avec l'étage de préamplification (12) et l'étage final (13) et les condensateurs de sortie (C3, C4), sont disposés sur une seule platine ou sur une seule carte de circuit imprimé, dans lequel de préférence il est prévu
que la platine ou la carte de circuit imprimé comprend deux zones de contact pour le raccordement électrique aux lignes d'alimentation (6, 7), dans lequel la première zone de contact est conçue pour le raccordement à la ligne d'alimentation positive (6) et la deuxième zone de contact est conçue pour le raccordement à la ligne d'alimentation négative (7) et/ou de préférence il est prévu
que la platine présente un évidement qui est entouré au moins partiellement par une des zones de contact et le raccordement électrique à une ligne d'alimentation (6, 7) a lieu grâce au fait qu'une tige d'encliquetage ou une vis s'emboîte dans l'évidement ou traverse l'évidement, afin de relier la zone de contact de manière électro-conductrice avec la ligne d'alimentation (6, 7).

12. Module antiparasites destiné à être monté ultérieurement sur des sources de tension bipolaires (4), plus particulièrement des sources de haute tension dans un groupe motopropulseur d'un véhicule électrique,
comprenant un boîtier dans lequel est logé un circuit amplificateur (2) d'un dispositif (1) selon l'une des revendications précédentes, dans lequel de préférence il est prévu
que le boîtier comprend des moyens de raccordement pour le raccordement mécanique et/ou électrique du circuit amplificateur (2) avec les lignes d'alimentation (6, 7) de la source de tension (4).

13. Dispositif selon l'une des revendications précédentes,
**caractérisé en ce que**
la source de signaux parasites (5) comprend un boîtier avec un espace pour le logement de la platine ou du module antiparasites, dans lequel la platine ou le module antiparasites est logé dans l'espace et est relié mécaniquement avec le boîtier de la source de signaux parasites (5).

14. Procédé de déparasitage d'une source de tension bipolaire (4), qui comprend une ligne d'alimentation positive (6) et une ligne d'alimentation négative (7), dans lequel un dispositif (1) selon l'une des revendications précédentes est utilisé et une liaison électrique est établie avec une électrode du dispositif (1) aussi bien par la ligne d'alimentation positive (6) que par la ligne d'alimentation négative (7).

15. Procédé selon la revendication 14,
**caractérisé en ce que**
la liaison électrique est établie grâce à une liaison enfichable ou une liaison vissée, de préférence dans une étape de travail avec la fixation mécanique de la platine ou du module antiparasites et/ou de préférence il est prévu
que, sur la ligne d'alimentation positive et négative (6, 7), soit monté respectivement un noyau de ferrite repliable, que celui-ci soit disposé d'une part sur la ligne d'alimentation entre une batterie ou un accumulateur rechargeable et d'autre part sur le raccordement du dispositif (1).
